(19) Europäisches Patentamt / European Patent Office / Office européen des brevets

(11) **EP 3 827 518 B1**

(12) **FASCICULE DE BREVET EUROPEEN**

(45) Date de publication et mention
de la délivrance du brevet:
**04.09.2024 Bulletin 2024/36**

(21) Numéro de dépôt: **19740012.0**

(22) Date de dépôt: **19.07.2019**

(51) Classification Internationale des Brevets (IPC):
***H03K 3/53*** *(2006.01)*

(52) Classification Coopérative des Brevets (CPC):
**H03K 3/53;** F24H 1/0018

(86) Numéro de dépôt international:
**PCT/EP2019/069462**

(87) Numéro de publication internationale:
**WO 2020/020760 (30.01.2020 Gazette 2020/05)**

(54) **DISPOSITIF DE DECHARGE ELECTRIQUE IMPULSIONNELLE**

GEPULSTE ELEKTRISCHE ENTLADUNGSVORRICHTUNG

PULSED ELECTRIC DISCHARGE DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.07.2018 FR 1856859**

(43) Date de publication de la demande:
**02.06.2021 Bulletin 2021/22**

(73) Titulaire: **ADM28 France**
**31100 Toulouse (FR)**

(72) Inventeur: **DOSTA, Frédéric**
**31870 LAGARDELLE SUR LEZE (FR)**

(74) Mandataire: **Argyma**
**14 Boulevard de Strasbourg**
**31000 Toulouse (FR)**

(56) Documents cités:
WO-A1-2017/094003    WO-A1-2018/001905
WO-A2-2015/067730    KR-A- 20110 097 465

## Description

*Domaine de l'Invention*

La présente invention se rapporte au domaine de l'électronique de puissance et concerne plus particulièrement un dispositif et un procédé de décharge électrique impulsionnelle dans un liquide. De tels procédé et dispositif trouvent notamment leur application au formage électrohydraulique, aux outils sismiques, à la stimulation de puits de pétrole ou à la lithotripsie.

*Etat de la technique*

En électronique de puissance, il est connu d'utiliser un dispositif de décharge électrique impulsionnelle permettant de transférer en une fraction de seconde un courant de très haute intensité sous très haute tension entre deux électrodes immergées dans un liquide. La tension entre les deux électrodes est fournie par une alimentation externe, comprise par exemple entre 1 et 40 kV, comprenant des modules capacitifs permettant de stocker l'énergie électrique et de la restituer sous la forme d'un courant de très haute intensité sous très haute tension. Il est cité document WO 2017094003 A1 qui décrit un dispositif de décharge électrique impulsionnelle dans un liquide. Le dispositif comprend une paire d'électrodes configurées pour être immergées dans le liquide et pour générer un arc électrique dans le liquide lorsqu'une tension prédéterminée est appliquée entre lesdites électrodes. Le dispositif comprend également une unité de décharge configurée pour appliquer une tension de décharge entre les électrodes de la paire d'électrodes. Lors d'une décharge, une chaleur intense est générée au niveau de l'arc électrique produit.

De manière connue, lors d'une décharge électrique impulsionnelle à haute tension dans l'eau, on distingue deux phases : une première phase dite « de pré-décharge » suivie d'une deuxième phase dite de « claquage ». La phase de pré-décharge est déclenchée par la mise sous tension de l'une des électrodes à une première valeur de tension élevée, par exemple de 20 kV, l'autre électrode étant reliée à une masse fixant la référence de potentiel, par exemple de 0 kV. Lors de la phase de pré-décharge, la tension définie entre les deux électrodes permet de chauffer l'eau jusqu'à ébullition pour créer un canal gazeux permettant de créer les conditions de claquage. Pendant cette montée en température de l'eau, la tension aux bornes des électrodes chute lentement jusqu'à une deuxième valeur de tension pour laquelle la phase de claquage se produit. Cette phase de claquage correspond à une décharge électrique se propageant dans le canal gazeux et créant un arc électrique permettant la circulation du courant entre les deux électrodes.

Cependant, ce type de dispositif présente plusieurs inconvénients, notamment dans son application au formage électrohydraulique d'une pièce métallique.

Tout d'abord, le niveau de tension au moment de la création de l'arc n'est pas maitrisé. L'énergie concentrée entre les électrodes, qui est ensuite convertie en onde de pression, n'est donc pas constante d'un tir à un autre. Il en résulte que, d'un essai à l'autre, la pression de formage appliquée sur la pièce n'est pas identique. Or, de telles différences de formage peuvent se révéler trop importantes de sorte qu'une partie des pièces produites ne soient pas conformes. De plus, dans le cas d'un formage réalisé à partir de plusieurs paires d'électrodes, les délais de création de l'arc sont de l'ordre de la propagation de l'onde de choc. Or, l'écart moyen entre les temps de claquage pouvant se révéler important, la synchronisation des déclenchements des différentes ondes de choc n'est donc pas assurée et le formage des pièces peut présenter des inhomogénéités, ce qui présente des inconvénients majeurs.

*Exposé de l'invention*

La présente invention a pour but de remédier au moins en partie à ces inconvénients en proposant une solution simple, fiable et efficace de dispositif d'amplification de puissance. À cet effet, l'invention a tout d'abord pour objet un dispositif de décharge électrique impulsionnelle dans un liquide, de préférence de l'eau, ledit dispositif comprenant :

- au moins une paire d'électrodes configurées pour être immergées dans ledit liquide et pour générer un arc électrique dans ledit liquide lorsqu'une tension prédéterminée est appliquée entre lesdites électrodes,

- au moins une unité de chauffage configurée pour chauffer ledit liquide pendant une durée dite « de chauffage », et

- au moins une unité de décharge configurée pour appliquer une tension de décharge entre les électrodes de l'au moins une paire d'électrodes,

- au moins une unité de commande configurée pour commander l'au moins une unité de chauffage afin que ladite unité de chauffage chauffe le liquide pendant la durée de chauffage et pour commander, au bout de ladite durée de chauffage quand le liquide a atteint une température prédéterminée, l'au moins une unité de décharge afin que ladite au moins unité de décharge applique la tension prédéterminée entre les électrodes de l'au moins une paire d'électrodes et génère ainsi une décharge électrique dans le liquide.

Le dispositif selon l'invention permet de déclencher la décharge entre les électrodes à un instant prédéterminé de sorte que les décharges soient reproductibles à l'identique d'un tir au suivant. Dans son application au formage électrohydraulique, l'invention permet ainsi de garantir une fiabilité et une précision d'un tir à l'autre à afin d'obtenir une uniformité entre les produits.

Cette invention permet de régler différents paramètres pour optimiser l'efficacité de la décharge comme, par exemple, augmenter la distance inter-électrodes afin d'augmenter la qualité de l'apport d'énergie ou bien réduire la conductivité du milieu liquide afin de rendre le déclenchement de l'arc électrique plus stable. Le dispositif selon l'invention ne nécessite pas de câblage externe complexe et peut ainsi être utilisé dans une application embarquée, par exemple en fond de puits pour une application sismique.

De préférence, le nombre d'unité(s) de chauffage est égal au nombre d'unité(s) de décharge. En variante, le dispositif peut comprendre un nombre d'unités de décharge supérieur au nombre d'unités de chauffage.

De préférence encore, le dispositif comprend une unique unité de commande reliée à toutes les unités de chauffage et de décharge afin de simplifier l'architecture du dispositif.

Dans une forme de réalisation, chaque unité de chauffage comprend un module capacitif, relié à l'une des électrodes de l'au moins une paire d'électrodes, comprenant par exemple un ou plusieurs condensateurs, et un interrupteur dit « de chauffage » relié d'une part audit module capacitif et d'autre part à l'autre électrode de la paire d'électrodes.

Dans une forme de réalisation, chaque unité de décharge comprend un module capacitif, relié à l'une des électrodes de l'au moins une paire d'électrodes, comprenant par exemple un ou plusieurs condensateurs, et un interrupteur dit « de décharge » relié d'une part audit module capacitif et d'autre part à l'autre électrode de la paire d'électrodes.

De manière préférée, la durée de chauffage est prédéterminée afin de rendre le déclenchement de la décharge fixe d'un tir à un autre et de garder un dispositif simple et efficace.

Selon un aspect de l'invention, l'au moins une unité de commande comprend un compteur et est configurée pour déclencher ledit compteur lorsque ladite moins une unité de commande active l'au moins une unité de chauffage et pour activer l'au moins une unité de décharge lorsque ledit compteur a atteint la durée de chauffage. Un tel compteur représente un moyen simple pour mesurer la durée de chauffage prédéterminée.

Avantageusement, la durée de chauffage est comprise entre 5 et 500 ms afin de permettre de déclencher la décharge de manière certaine et efficace.

En variante ou en complément, le dispositif, notamment l'au moins une unité de commande, peut être configuré pour surveiller l'évolution de la tension de chauffage et interrompre le chauffage du liquide entre les électrodes par l'au moins une unité de chauffage lorsque la tension de chauffage a atteint un seuil prédéterminé traduisant un transfert d'énergie équivalent à l'énergie nécessaire pour atteindre la température d'ébullition entre les électrodes et permettre la génération d'une décharge électrique impulsionnelle. L'énergie nécessaire est fonction du volume d'eau à chauffer et dépend de la géométrie des électrodes. La valeur de l'énergie peut être déterminée en utilisant la formule suivant :

$$E = \rho \times Cp \times V \times (Te - Ti)$$

où E correspond à l'énergie nécessaire pour atteindre la température d'ébullition entre les électrodes, $\rho$ est la densité du liquide, Cp est la capacité thermique isobare du liquide, V correspond au volume d'eau à chauffer entre les électrodes, Te est la température d'ébullition du liquide et Ti est la température initiale (i.e. avant chauffage) du liquide.

En variante ou en complément, le dispositif, notamment l'au moins une unité de commande, peut être configuré pour surveiller l'évolution de l'intensité du courant circulant entre les électrodes de l'au moins une paire d'électrodes et interrompre le chauffage du liquide entre lesdites électrodes par l'au moins une unité de chauffage lorsque l'intensité dudit courant a atteint un seuil prédéterminé traduisant un transfert d'énergie équivalent à l'énergie nécessaire pour atteindre la température d'ébullition entre les électrodes et permettre la génération d'une décharge électrique impulsionnelle, comme expliqué ci-avant.

Selon une caractéristique de l'invention, l'au moins une unité de chauffage est configurée pour délivrer une tension de chauffage entre les électrodes afin de chauffer le liquide, l'utilisation d'une tension appliquée entre les électrodes étant un moyen simple et efficace pour chauffer le liquide.

De manière avantageuse, la tension de chauffage est comprise entre 0,1 et 5 kV.

Avantageusement, la tension de décharge est comprise entre 1 et 40 kV.

Selon un aspect de l'invention, le dispositif comprend une unique paire d'électrodes.

Dans une forme de réalisation du dispositif, le dispositif comprend une unique paire d'électrodes, une unique unité de chauffage, une unique unité de décharge et une unique unité de commande.

Dans une autre forme de réalisation, le dispositif comprend une unique paire d'électrodes, une pluralité d'unités de chauffage, une pluralité d'unités de décharge et une unique unité de commande. L'utilisation de plusieurs unités de chauffage permet de réduire la durée de chauffage. L'utilisation de plusieurs unités de décharge permet d'augmenter la puissance de la décharge de courant entre les électrodes, notamment afin de former des pièces métalliques complexes de manière précise et efficace.

Dans une forme de réalisation particulière, le dispositif comprend une paire d'électrodes, deux unités de chauffage, deux unités de décharge et une unité de commande.

Dans une autre forme de réalisation particulière, le dispositif comprend une paire d'électrodes, trois unités de chauffage, trois unités de décharge et une unité de commande.

L'invention concerne aussi un procédé de génération d'une décharge électrique dans un liquide à partir d'un dispositif de décharge électrique impulsionnelle, ledit procédé comprenant une étape de chauffage dudit liquide pendant une durée de chauffage au terme de laquelle le liquide a atteint une température prédéterminée et, une fois la durée de chauffage écoulée, une étape de déclenchement d'une décharge électrique impulsionnelle.

D'autres caractéristiques et avantages de l'invention apparaîtront lors de la description qui suit faite en regard des figures annexées et données à titre d'exemples non limitatifs et dans lesquelles des références identiques sont données à des objets semblables.

*Brève description des dessins*

La figure 1 illustre schématiquement une première forme de réalisation du dispositif de décharge électrique impulsionnelle selon l'invention.
La figure 2 illustre schématiquement une deuxième forme de réalisation du dispositif de décharge électrique impulsionnelle selon l'invention.
La figure 3 illustre schématiquement un mode de réalisation du procédé selon l'invention.

*Description détaillée de modes de réalisation de l'invention*

Le dispositif selon l'invention permet de réaliser des décharges électriques impulsionnelles dans un liquide, par exemple de l'eau (formage, prospection pétrolière...) ou du sang (lithotripsie). Le dispositif selon l'invention peut notamment être utilisé pour réaliser du formage électrohydraulique, pour réaliser une prospection géophysique en générant des ondes sismiques, pour améliorer la production de puits de pétrole ou pour traiter des calculs rénaux par lithotripsie.

Le dispositif selon l'invention comprend au moins une paire d'électrodes, au moins une unité de chauffage, au moins une unité de décharge et au moins une unité de commande.

Chaque paire d'électrodes est configurée pour être immergée dans un liquide et pour générer un arc électrique dans ledit liquide lorsqu'une tension prédéterminée est appliquée entre les électrodes de ladite paire.

Chaque unité de chauffage est configurée pour chauffer le liquide, en fournissant une tension aux bornes des électrodes de chaque paire d'électrode, pendant une durée dite « de chauffage ».

Chaque unité de décharge est configurée pour appliquer une tension de décharge entre les électrodes de l'au moins une paire d'électrodes.

De préférence, mais non limitativement, le dispositif comprend une unique unité de commande. L'unité de commande est configurée pour commander simultanément la ou les unités de chauffage afin que ladite ou lesdites unités de chauffage chauffent le liquide pendant la durée de chauffage. L'unité de commande est également configurée pour commander, au bout de ladite durée de chauffage, la ou les unités de décharge afin que ladite ou lesdites unités de décharge appliquent la tension prédéterminée entre les électrodes de l'au moins une paire d'électrodes et génère ainsi une décharge électrique dans le liquide.

De préférence, lorsqu'il y a plusieurs unités de chauffage et plusieurs unités de décharge, l'au moins une unité de commande est configurée pour commander les unités de chauffage de manière synchronisée d'une part et pour commander les unités de décharge de manière synchronisée d'autre part.

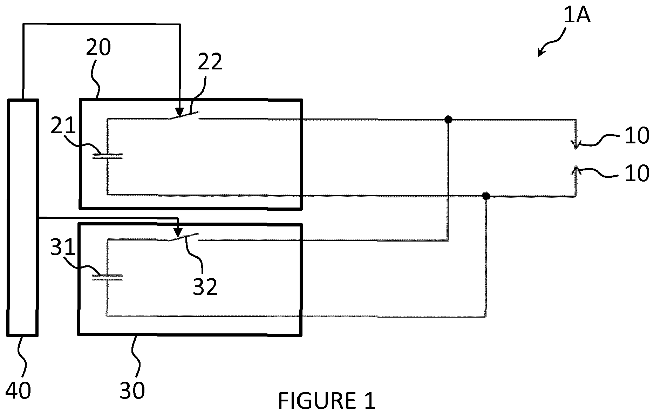

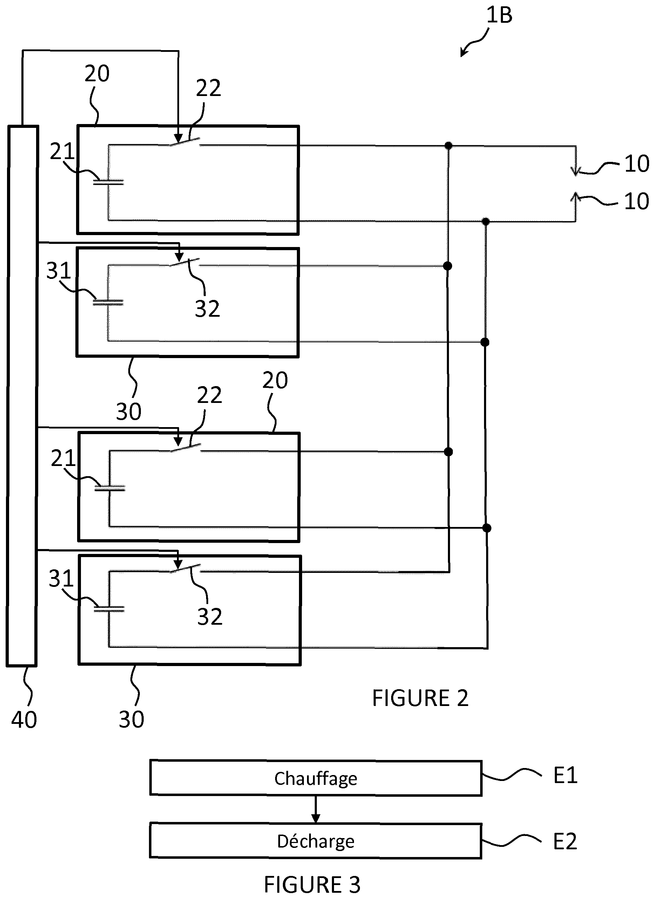

On a représenté à la figure 1 une première forme de réalisation du dispositif 1A selon l'invention et à la figure 2 une deuxième forme de réalisation du dispositif 1B selon l'invention. Dans la première forme de réalisation, le dispositif 1A comprend une unique paire d'électrodes 10, une unique unité de chauffage 20, une unique unité de décharge 30 et une unique unité de commande 40. Dans la deuxième forme de réalisation, le dispositif 1B comprend une unique paire d'électrodes 10, deux unités de chauffage 20, deux unités de décharge 30 et une unique unité de commande 40.

La paire d'électrodes 10 est configurée pour être immergée dans le liquide dans lequel on veut réaliser une ou plusieurs décharges électriques impulsionnelles. Plus précisément, la paire d'électrodes 10 est configurée pour recevoir une tension appliquée entre les deux électrodes 10 de la paire d'électrodes 10 afin de générer un arc électrique dans le liquide lorsque certaines conditions sont réunies, comme cela sera expliqué ci-après.

Lors d'un tir, les charges électriques se propagent depuis l'extrémité d'une électrode 10 vers l'extrémité de l'autre électrode 10 de la paire dans le volume de liquide et de gaz les séparant. Les électrodes 10 peuvent par exemple être de forme générale cylindrique creuse, symétrique de révolution. De préférence, les électrodes 10 sont alignées "bout à bout", c'est-à-dire agencées de sorte que leurs axes longitudinaux respectifs (non représentés) coïncident et qu'elles présentent des extrémités libres éloignées d'une distance fixe prédéterminée, par exemple comprise entre 1 et 50 mm environ, préférentiellement entre 1 et 25 mm (l'augmentation de la distance entre les électrodes 10 permettant d'augmenter l'énergie déposée entre lesdites électrodes 10), et en regard l'une de l'autre selon la direction axiale (direction des axes de symétrie). Lors d'une décharge électrique impulsionnelle, l'arc électrique se produit entre ces extrémités libres, dont les faces extrêmes annulaires en regard sont sensiblement planes (dans des plans transversaux). Comme illustré sur les figures 1 et 2, les extrémités axiales opposées des électrodes, dites extrémités de connexion, sont reliées chacune d'une part à l'au moins une unité de chauffage 20 et d'autre part à l'au moins une unité de décharge 30.

Dans chacune des formes de réalisation des figures 1 et 2, chaque unité de chauffage 20 est configurée pour chauffer ledit liquide pendant une durée dite « de chauffage ». Cette durée de chauffage peut être prédéterminée, par exemple en étant choisie en fonction du liquide, ou bien adaptée en temps réel, par exemple en surveillant l'évolution de la tension aux bornes des électrodes 10.

La durée de chauffage permet de s'assurer que le liquide est suffisamment chaud pour permettre la génération d'une décharge électrique impulsionnelle entre les deux électrodes 10 lorsqu'une tension dite « de décharge » est appliquée par l'au moins une unité de décharge 30. Par exemple, la durée de chauffage peut être choisi comme la durée nécessaire pour chauffer jusqu'à la vaporisation du volume du liquide située entre les électrodes.

Le chauffage du liquide peut être piloté à partir d'un ou plusieurs des paramètres suivant : le temps, le courant ou la tension de manière à déterminer la durée de chauffage. De même, la durée de chauffage peut correspondre à la durée nécessaire pour transformer le liquide en phase gazeuse, par exemple la transformation de l'eau liquide en vapeur d'eau. En effet, le changement de phase d'un liquide vers un gaz modifie la résistivité du milieu et ainsi le courant circulant entre les électrodes.

Dans chacune des formes de réalisation des figures 1 et 2, l'unité de commande 40, par exemple un calculateur ou un microcontrôleur, peut par exemple surveiller le courant circulant entre les électrodes 10 ou la tension définie aux bornes des électrodes 10 et commander l'au moins une unité de décharge 30 lorsque l'intensité dudit courant ou ladite tension atteignent un seuil prédéterminé, par exemple de 1 kA ou de 5 kV, pour lequel la température du liquide entre les électrodes 10 est suffisante pour produire une décharge électrique impulsionnelle entre lesdites deux électrodes 10.

A cette fin, de préférence, chaque unité de chauffage 20 comprend un générateur de chauffage 21 configuré pour délivrer une tension dite « de chauffage » aux bornes des électrodes 10 de la paire d'électrodes 10 afin de chauffer le liquide. Ce générateur de chauffage 21 peut se présenter sous la forme d'une pluralité de condensateurs, ou d'un générateur de tension à courant constant. Une pluralité de condensateurs permet de fournir une tension de l'ordre de quelques kilovolts en un temps très court, par exemple de l'ordre de 10 ms, tandis qu'un générateur de tension à courant constant permet de générer une tension plus faible, de l'ordre de quelques centaines de Volts, en un temps plus long, par exemple de l'ordre de 100 ms. La tension de chauffage peut par exemple être comprise entre 100 V et 5 kV. Chaque unité de chauffage 20 comprend également un interrupteur dit « de chauffage » 22 commandé en ouverture ou en fermeture par l'unité de commande 40.

Dans chacune des formes de réalisation des figures 1 et 2, chaque unité de décharge 30 est configurée pour appliquer une tension de décharge aux bornes des électrodes 10 de la paire d'électrodes 10. Cette tension de décharge permet de déclencher la génération décharge électrique impulsionnelle entre les deux électrodes 10. La valeur de la tension de décharge peut par exemple être de l'ordre de 20 kV. Afin de générer la tension de décharge, chaque unité de décharge 30 comprend un générateur de décharge 31, se présentant par exemple sous la forme d'une pluralité de condensateurs, et un interrupteur dit « de décharge » 32 commandé en ouverture ou en fermeture par l'unité de commande 40.

On notera que le générateur de chauffage 21 et le générateur de décharge 22 peuvent être deux entités physiques distinctes ou bien être une unique entité qui est configurée pour délivrer des tensions de valeurs différentes permettant respectivement de chauffer le liquide et de générer une décharge électrique impulsionnelle dans ledit liquide.

La ou les unités de chauffage 20 et la ou les unités de décharge 30 sont commandées par l'unité de commande 40. Plus précisément, l'unité de commande 40 est configurée pour commander la ou les unités de chauffage 20 afin que ladite ou lesdites unités de chauffage 20 chauffent le liquide pendant la durée de chauffage et pour commander, au bout de ladite durée de chauffage, la ou les unités de décharge 30 afin que ladite ou lesdites unités de décharge 30 appliquent la tension prédéterminée aux bornes des électrodes 10 de manière à générer un arc électrique dans le liquide.

Ainsi, en d'autres termes, l'unité de commande 40 active tout d'abord la ou les unités de chauffage 20 jusqu'à ce que le liquide ait atteint une température suffisante pour permettre la génération d'une décharge électrique impulsionnelle, c'est-à-dire pendant la durée de chauffage, puis, une fois le liquide chauffé, interrompt le fonctionnement de la ou des unités de chauffage 20 et déclenchent, de préférence simultanément, la ou les unités de décharge 30 afin de générer une décharge électrique impulsionnelle entre les deux électrodes 10.

Lorsque la durée de chauffage est prédéterminée, l'unité de commande 40 peut comprendre un compteur (non représenté) qui se déclenche lorsque l'unité de commande 40 active la ou les unités de chauffage 20 et que l'unité de commande 40 surveille de sorte à stopper le fonctionnement de la ou des unités de chauffage 20 lorsque le compteur a atteint la durée de chauffage. Lorsque la durée de chauffage n'est pas prédéterminée, l'unité de commande 40 peut, une fois la ou les unités de chauffage 20 activées, surveiller l'évolution de la tension de chauffage et stopper le fonctionnement de ladite ou desdites unités de chauffage 20 lorsque la tension de chauffage a atteint un seuil prédéterminé, traduisant un transfert d'énergie équivalent à l'énergie nécessaire pour atteindre la température d'ébullition entre les électrodes et permettre la génération d'une décharge électrique impulsionnelle dès que la ou les unités de décharge 30 ont permis d'atteindre la tension de décharge entre les électrodes 10.

Dans la deuxième forme de réalisation illustrée à la figure 2, les deux unités de chauffage 20 sont montées en parallèle et reliées d'une part à l'unité de commande 40 et d'autre part à la paire d'électrodes 10. De même, les deux unités de décharge 30 sont montées en parallèle et reliées d'une part à l'unité de commande 40 et d'autre part à la paire d'électrodes 10. Chaque unité de chauffage 20 comprend un générateur de chauffage 21 et un interrupteur de chauffage 22. Chaque unité de décharge 30 comprend un générateur de décharge 31 et un interrupteur de décharge 32.

La connexion des unités de chauffage 20 en parallèle entre elles permet de chauffer plus rapidement le liquide. La connexion des unités de décharge 30 en parallèle entre elles permet d'augmenter la puissance fournie à la paire d'électrodes 10 de manière aisée et modulable tout en s'assurant que ladite puissance soit fournie en même temps entre les électrodes 10, les unités de décharge 30 étant ainsi synchronisées entre elles.

On notera qu'il est possible de connecter aisément en parallèle plus de deux unités de chauffage 20 et de même plus de deux unités de décharge 30, par exemple en les ajoutant respectivement à une ou des unités de chauffage 20 et à une ou des unités de décharge 30 d'un dispositif existant, afin d'augmenter davantage la puissance si nécessaire. De préférence, le même nombre d'unités de chauffage et d'unités de décharge est utilisé, dans que cela ne soit limitatif de la portée de la présente invention.

Un tel dispositif 1B est particulièrement efficace dans une application au formage hydraulique pour lequel la puissance nécessaire au formage est très importante et nécessite la mise en parallèle de plusieurs unités de décharge 30.

L'invention va maintenant être décrite dans sa mise en oeuvre en référence à la figure 3 pour la première forme de réalisation et la deuxième forme de réalisation du dispositif 1A, 1B lorsque ledit dispositif 1A, 1B est immergé dans un liquide.

Tout d'abord, lorsqu'une décharge électrique impulsionnelle doit être réalisée, l'unité de commande 40 va commander la ou les unités de chauffage 20 afin que ladite ou lesdites unités de chauffage 20 chauffent le liquide entre les électrodes 10 dans une étape E1.

A cette fin, l'unité de commande 40 ferme l'interrupteur de chauffage 22 de la ou des unités de chauffage 20 de sorte que le générateur de chauffage 21 délivre la tension de chauffage à la paire d'électrodes 10 pendant la durée de chauffage.

Lorsque la durée de chauffage est prédéterminée, l'unité de commande 40 déclenche le compteur en même temps qu'il ferme le ou les interrupteurs de chauffage 22 de la ou des unités de chauffage 21 puis ouvre ledit interrupteur de chauffage 22 une fois la durée de chauffage écoulée. Lorsque la durée de chauffage n'est pas connue à l'avance, l'unité de commande 40 surveille la tension aux bornes respectivement de la paire d'électrodes 10 afin d'activer la ou les unités de décharge 30 lorsque la tension observée aura atteint un seuil de tension prédéterminé caractérisant une accumulation d'énergie dans le liquide entre les électrodes 10 suffisante pour permettre la décharge. L'unité de commande 40 peut aussi surveiller la tension, par exemple entre 100 V et 5 kV, et le courant, dont l'intensité est par exemple comprise entre 10 A et 1 kA, afin de calculer l'énergie, par exemple comprise entre quelques centaines de Joules et de l'ordre de 10 kJ, réellement déposée dans le liquide et activer la ou les unités de décharge 30 quand l'énergie nécessaire est atteinte.

Une fois la durée de chauffage écoulée (i.e. la durée prédéterminée écoulée ou le seuil de tension prédéterminé atteint), l'unité de commande 40 active la ou les unités de décharge 30 afin que ladite ou lesdites unités de décharge 30 déclenchent une décharge électrique impulsionnelle entre les électrodes 10 dans une étape E2.

A cette fin, simultanément à l'ouverture du ou des interrupteurs de chauffage 22 de la ou des unités de chauffage 20 ou immédiatement postérieurement, par exemple entre 5 et 500 ms après ladite ouverture (sachant qu'il peut être nécessaire d'attendre par exemple plusieurs secondes pour recharger les condensateurs), l'unité de commande 40 ferme le ou les interrupteurs de décharge 32 de la ou des unités de décharge 30 afin que le ou les générateurs de décharge 31 de la ou des unités de décharge 30 appliquent la tension de décharge, par exemple de l'ordre de 20 kV, entre les électrodes 10 afin de générer une décharge électrique impulsionnelle entre les deux électrodes 10 de la paire d'électrodes 10.

Les ondes générées par cette décharge sont ensuite utilisées pour l'application visée, par exemple pour former une pièce, qui peut être métallique ou en un matériau plastique.

L'invention permet donc avantageusement de s'assurer que le liquide est chauffé de manière précise afin de déclencher une décharge électrique impulsionnelle à un instant prédictible, ce qui permet de rendre le procédé répétable et reproductible à l'identique. En particulier, dans un dispositif 1B à plusieurs unités de décharge, l'invention permet de déclencher en un seul instant une unique décharge électrique impulsionnelle de forte puissance de manière, contrairement à un dispositif à plusieurs paires d'électrodes de l'art antérieur qui nécessite une synchronisation pouvant s'avérer complexe et imprécise.

Il est à noter que la présente invention n'est pas limitée aux exemples décrits ci-dessus et est susceptible de nombreuses variantes accessibles à l'homme de l'art.

**Revendications**

1. Dispositif (1A, 1B) de décharge électrique impulsionnelle dans un liquide, ledit dispositif (1A, 1B) étant **caractérisé en ce qu'**il comprend :

- au moins une paire d'électrodes (10) configurées pour être immergées dans ledit liquide et pour générer un arc électrique dans ledit liquide lorsqu'une tension prédéterminée est appliquée entre lesdites électrodes (10),

- au moins une unité de chauffage (20) configurée pour chauffer ledit liquide pendant une durée dite « de chauffage »,

- au moins une unité de décharge (30) configurée pour appliquer une tension de décharge entre les électrodes (10) de l'au moins une paire d'électrodes (10), et

- au moins une unité de commande (40) configurée pour commander l'au moins une unité de chauffage (20) afin que ladite unité de chauffage (20) chauffe le liquide pendant la durée de chauffage et pour commander, au bout de ladite durée de chauffage quand le liquide a atteint une température prédéterminée, l'au moins une unité de décharge (30) afin que ladite au moins une unité de décharge (30) applique la tension prédéterminée entre les électrodes (10) de l'au moins une paire d'électrodes (10) et génère ainsi une décharge électrique dans le liquide.

2. Dispositif (1A, 1B) selon la revendication 1, dans lequel la durée de chauffage est prédéterminée.

3. Dispositif (1A, 1B) selon l'une des revendications précédentes, dans lequel l'au moins une unité de commande (40) comprend un compteur et est configurée pour déclencher ledit compteur lorsque ladite au moins une unité de commande (40) active l'au moins une unité de chauffage (20) et pour activer l'au moins une unité de décharge (30) lorsque ledit compteur a atteint la durée de chauffage.

4. Dispositif (1A, 1B) selon l'une des revendications précédentes, dans lequel la durée de chauffage est comprise entre 5 et 500 ms.

5. Dispositif (1A, 1B) selon l'une des revendications précédentes, dans lequel l'au moins une unité de chauffage (20) est configurée pour délivrer une tension de chauffage entre les électrodes (10) afin de chauffer le liquide.

6. Dispositif (1A, 1B) selon la revendication précédente, dans lequel la tension de chauffage est comprise entre 0,1 et 5 kV.

7. Dispositif (1A, 1B) selon l'une des revendications précédentes, dans lequel la tension de décharge est comprise entre 1 et 40 kV.

8. Dispositif (1A, 1B) selon l'une des revendications précédentes, comprenant une unique paire d'électrodes (10), une unique unité de chauffage, une unique unité de décharge et une unique unité de commande.

9. Dispositif (1A, 1B) selon l'une des revendications précédentes, comprenant une unique paire d'électrodes (10), une pluralité d'unités de chauffage, une pluralité d'unités de décharge et une unique unité de commande.

10. Procédé de génération d'une décharge électrique dans un liquide à partir d'un dispositif (1A, 1B) de décharge électrique impulsionnelle, ledit procédé comprenant une étape (E1) de chauffage dudit liquide pendant une durée de chauffage au terme de laquelle le liquide a atteint une température prédéterminée et, une fois la durée de chauffage écoulée, une étape (E2) de déclenchement d'une décharge électrique impulsionnelle.

**Patentansprüche**

1. Vorrichtung (1A, 1B) zur gepulsten elektrischen Entladung in einer Flüssigkeit, wobei die Vorrichtung (1A, 1B) **dadurch gekennzeichnet ist, dass** sie umfasst:

- mindestens ein Paar Elektroden (10), die so konfiguriert sind, dass sie in die Flüssigkeit eingetaucht werden und einen Lichtbogen in der Flüssigkeit erzeugen, wenn eine vorbestimmte Spannung zwischen den Elektroden (10) angelegt wird,

- mindestens eine Heizeinheit (20), die so konfiguriert ist, dass sie die Flüssigkeit während einer sogenannte "Heizzeit" erhitzt,

- mindestens eine Entladungseinheit (30), die so konfiguriert ist, dass sie eine Entladungsspannung zwischen den Elektroden (10) des mindestens einen Paars Elektroden (10) anlegt, und

- mindestens eine Steuereinheit (40), die so konfiguriert ist, dass sie die mindestens eine Heizeinheit (20) so steuert, dass die Heizeinheit (20) die Flüssigkeit während der Heizzeit erwärmt und am Ende der Heizzeit, wenn die Flüssigkeit eine vorbestimmte Temperatur erreicht hat, die mindestens eine Entladungseinheit (30) so steuert, dass die mindestens eine Entladungseinheit (30) die vorbestimmte Spannung zwischen den Elektroden (10) des mindestens einen Paars Elektroden (10) anlegt und dadurch eine elektrische Entladung in der Flüssigkeit erzeugt.

2. Vorrichtung (1A, 1B) nach Anspruch 1, wobei die Heizzeit vorbestimmt ist.

3. Vorrichtung (1A, 1B) nach einem der vorhergehenden Ansprüche, wobei die mindestens eine Steuereinheit (40) einen Zähler umfasst und so konfiguriert ist, dass sie den Zähler auslöst, wenn die mindestens eine Steuereinheit (40) die mindestens eine Heizeinheit (20) aktiviert, und die mindestens eine Entladungseinheit (30) aktiviert, wenn der Zähler die Heizzeit erreicht hat.

4. Vorrichtung (1A, 1B) nach einem der vorhergehenden Ansprüche, wobei die Heizzeit zwischen 5 und 500 ms liegt.

5. Vorrichtung (1A, 1B) nach einem der vorhergehenden Ansprüche, wobei die mindestens eine Heizeinheit (20) so konfiguriert ist, dass sie eine Heizspannung zwischen den Elektroden (10) bereitstellt, um die Flüssigkeit zu erwärmen.

6. Vorrichtung (1A, 1B) nach dem vorhergehenden Anspruch, wobei die Heizspannung zwischen 0,1 bis 5 kV liegt.

7. Vorrichtung (1A, 1B) nach einem der vorhergehenden Ansprüche, wobei die Entladungsspannung zwischen 1 und 40 kV liegt.

8. Vorrichtung (1A, 1B) nach einem der vorhergehenden Ansprüche, die ein einziges Paar Elektroden (10), eine einzige Heizeinheit, eine einzige Entladungseinheit und eine einzige Steuereinheit umfasst.

9. Vorrichtung (1A, 1B) nach einem der vorhergehenden Ansprüche, die ein einziges Paar Elektroden (10), eine Vielzahl von Heizeinheiten, eine Vielzahl von Entladungseinheiten und eine einzige Steuereinheit umfasst.

10. Verfahren zum Erzeugen einer elektrischen Entladung in einer Flüssigkeit auf der Basis einer Vorrichtung (1A, 1B) zur gepulsten elektrischen Entladung, wobei das Verfahren einen Schritt (E1) des Erhitzens der Flüssigkeit während einer Heizzeit, nach der die Flüssigkeit eine vorbestimmte Temperatur erreicht hat, und nach Ablauf der Heizzeit einen Schritt (E2) des Auslösens einer gepulsten elektrischen Entladung umfasst.

**Claims**

1. A device (1A, 1B) for pulsed electrical discharge in a liquid, said device (1A, 1B) being **characterized in that** it comprises:

    - at least one pair of electrodes (10) configured to be immersed in said liquid and to generate an electric arc in said liquid when a predetermined voltage is applied between said electrodes (10),
    - at least one heating unit (20) configured to heat said liquid for a "heating" period,
    - at least one discharge unit (30) configured to apply a discharge voltage between the electrodes (10) of said at least one pair of electrodes (10), and
    - at least one control unit (40) configured to control said at least one heating unit (20) so that said heating unit (20) heats the liquid during the heating period and to control, at the end of said heating period when the liquid has reached a predetermined temperature, said at least one discharge unit (30) so that said at least one discharge unit (30) applies the predetermined voltage between the electrodes (10) of said at least one pair of electrodes (10) and thus generates an electrical discharge in the liquid.

2. The device (1A, 1B) as claimed in claim 1, wherein the heating period is predetermined.

3. The device (1A, 1B) according to one of the preceding claims, wherein said at least one control unit (40) comprises a counter and is configured to trigger said counter when said at least one control unit (40) activates the at least one heating unit (20) and to activate said at least one discharge unit (30) when said counter has reached the heating period.

4. The device (1A, 1B) according to one of the preceding claims, wherein the heating period is between 5 and 500 ms.

5. The device (1A, 1B) according to one of the preceding claims, wherein said at least one heating unit (20) is configured to deliver a heating voltage between the electrodes (10) in order to heat the liquid.

6. The device (1A, 1B) according to the preceding claim, wherein the heating voltage is between 0.1 and 5 kV.

7. The device (1A, 1B) according to one of the preceding claims, wherein the discharge voltage is between 1 and 40 kV.

8. The device (1A, 1B) according to one of the preceding claims, comprising a single pair of electrodes (10), a single heating unit, a single discharge unit and a single control unit.

9. The device (1A, 1B) according to one of the preceding claims, comprising a single pair of electrodes (10), a plurality of heating units, a plurality of discharge units and a single control unit.

10. A method of generating an electrical discharge in a liquid from a pulsed electrical discharge device (1A, 1B), said method comprising a step (E1) of heating said liquid for a heating period at the end of which the liquid has reached a predetermined temperature and, once the heating period has elapsed, a step (E2) of triggering a pulsed electrical discharge.

FIGURE 1

1B

20

22

21

10

10

31

32

30

20

22

21

31

32

40

30

FIGURE 2

| Chauffage | E1 |

| Décharge | E2 |

FIGURE 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2017094003 A1